# EUROPÄISCHE PATENTSCHRIFT

(11) **EP 3 275 018 B1**
(45) Veröffentlichungstag und Bekanntmachung des Hinweises auf die Patenterteilung: **21.07.2021**
(21) Anmeldenummer: 16708114.0
(22) Anmeldetag: 01.03.2016
(51) Int. Cl.: H01L 25/16, H05K 1/02, H05K 1/18, H01L 33/54, H01L 33/64

(54) **TRÄGER MIT PASSIVER KÜHLFUNKTION FÜR EIN HALBLEITERBAUELEMENT**
CARRIER WITH A PASSIVE COOLING FUNCTION FOR A SEMICONDUCTOR COMPONENT
SUPPORT À FONCTION DE REFROIDISSEMENT PASSIF POUR UN COMPOSANT SEMI-CONDUCTEUR

(30) Priorität: 26.03.2015 DE 102015104641
(43) Veröffentlichungstag der Anmeldung: 31.01.2018
(73) Patentinhaber: TDK Electronics AG, 81671 München (DE); AT & S Austria Technologie & Systemtechnik Aktiengesellschaft, 8700 Leoben (AT)
(72) Erfinder: FEICHTINGER, Thomas, 8010 Graz (AT); DERNOVSEK, Oliver, 8501 Lieboch (AT); RINNER, Franz, 8530 Deutschlandsberg (AT); VOCKENBERGER, Christian, 8700 Leoben (AT)
(74) Vertreter: Epping - Hermann - Fischer
(86) Internationale Anmeldenummer: PCT/EP2016/054321
(87) Internationale Veröffentlichungsnummer: WO 2016/150662

(56) Entgegenhaltungen:
- WO-A1-2014/202282
- DE-A1-102010 038 154
- US-A1- 2006 145 328
- US-A1- 2013 009 325
- US-A1- 2013 269 986
- US-A1- 2014 185 258

## Beschreibung

Träger mit passiver Kühlfunktion für ein Halbleiterbauelement Die vorliegende Erfindung betrifft einen Träger für ein Halbleiterbauelement sowie eine Vorrichtung, die einen Träger und ein auf dem Träger angeordnetes Halbleiterbauelement aufweist.

Bei dem Halbleiterbauelement kann es sich hierbei insbesondere um eine Leuchtdiode handeln.

Bei dem Design von Trägern für Leuchtdioden spielen verschiedene Aspekte wie die Lichtausbeute, die Lebensdauer und das thermische Management eine wichtige Rolle. Neben den funktionalen und thermomechanischen Anforderungen gibt es auch geometrische Probleme zu lösen. Speziell bei mobilen Anwendungen, beispielsweise bei in den Kamerablitz eines Mobiltelefons integrierten Leuchtdioden, sollte der Träger und weitere Bauelemente, wie etwa diskrete Schutzbauelemente und Sensoren, einen möglichst geringen Platzbedarf und eine möglichst geringe Bauhöhe aufweisen.

Eine weitere wichtige Anforderung an einen Träger für eine Leuchtdiode besteht darin, die Lichtabstrahlung der Leuchtdiode möglich ungehindert zu ermöglichen und dabei insbesondere Abschattungen zu vermeiden.

US 2013/0269986 A1 beschreibt ein Package, bei dem ein elektronisches Bauteil in einem Träger eingebettet ist. Das elektronische Bauteil ist mittels Metallisierungen mit einer Oberseite und einer Unterseite des Trägers elektrisch kontaktiert. Ferner ist auf der Oberseite des Trägers ein LED Chip angeordnet. Der Träger weist ein thermisches Via ("heat-conducting device") auf, das unmittelbar unterhalb des LED Chips angeordnet ist und sich durch den Träger hindurch erstreckt.

US 2014/185258 A1 beschreibt ein Substrat, in das ein passives Element eingebettet ist, das über Vias mit der Oberseite bzw. der Unterseite des Substrats kontaktiert ist.

DE 10 2010 038154 A1 beschreibt ein Laminatelektronikbauelement umfassend drei Halbleiterchips, die in einem Träger eingebettet sind. Die Halbleiterchips sind mittels strukturierter Metallisierungen mit der Oberseite und der Unterseite des Trägers elektrisch verbunden. Ferner weist das Laminatelektronikbauelement thermische Vias auf, die mit einigen der strukturierten Metallisierungen thermisch gekoppelt sind.

Aufgabe der vorliegenden Erfindung ist es, einen verbesserten Träger für ein Halbleiterbauelement bereitzustellen, der beispielsweise ein gutes thermisches Management ermöglicht.

Diese Aufgabe wird durch den Gegenstand des vorliegenden Anspruchs 1 gelöst.

Es wird ein Träger mit passiver Kühlfunktion für ein Halbleiterbauelement vorgeschlagen, der einen Grundkörper mit einer Oberseite und einer Unterseite und zumindest ein elektrisches Bauelement, das in den Grundkörper eingebettet ist, aufweist. Der Träger weist ferner ein erstes thermisches Via auf, das sich von der Oberseite des Grundkörpers zu dem zumindest einen elektrischen Bauelement erstreckt. Der Träger weist ein zweites thermisches Via auf, das sich von dem zumindest einen elektrischen Bauelement zu der Unterseite des Grundkörpers erstreckt. Das zumindest eine elektrische Bauelement ist durch das erste und das zweite thermische Via elektrisch kontaktiert.

Das erste und das zweite thermische Via erfüllen somit in dem Träger zwei Funktionen. Sie ermöglichen sowohl die elektrische Kontaktierung des zumindest einen eingebetteten Bauelementes als auch eine Reduzierung des thermischen Widerstands des Grundkörpers, da sie aufgrund ihrer hohen Wärmeleitfähigkeit dazu geeignet sind, von einem auf dem Träger aufgebrachten Halbleiterbauelement abgestrahlte Hitze schnell und effektiv von der Oberseite des Grundkörpers abzuleiten.

Dementsprechend sorgen die thermischen Vias für eine passive Kühlung des Trägers und/oder des Halbleiterbauelements. Als passive Kühlung wird hier die Kühlung von elektrischen oder elektronischen Geräten allein auf der Basis von "freier" Konvektion bezeichnet. Dabei kann Abwärme an die umgebende Luft abgeführt werden.

Dadurch, dass das zumindest eine elektrische Bauelement in dem Träger eingebettet ist, kann der Träger frei von auf der Oberseite aufgebrachten Bauelementen sein, sodass sich insgesamt eine geringe Höhe des Trägers realisieren lässt. Dadurch kann die insbesondere bei mobilen Anwendungen kritische Bauhöhe deutlich reduziert werden.

Der Träger kann dazu geeignet sein, dass das Halbleiterbauelement, beispielsweise ein Leuchtdiodenchip, unmittelbar auf dem Träger montiert werden kann. Dieses kann beispielsweise durch ein AuSn-Eutektikbonding oder ein AuSn-Reflow-Verfahren erfolgen. Der Träger ist dabei derart ausgestaltet, dass das Halbleiterbauelement, beispielsweise eine Leuchtdiode, auf der Oberseite des Grundkörpers angeordnet werden kann. Der Träger kann ein oder mehrere Halbleiterbauelemente aufnehmen.

Der Begriff "eingebettet" ist hier derart zu verstehen, dass das eingebettete elektrische Bauelement von allen Seiten von einer Schicht des Grundkörpers beziehungsweise einem thermischen Via umschlossen ist. In dem Grundkörper sind Öffnungen ausgebildet, in denen das elektrische Bauelement eingeschlossen ist. Das elektrische Bauelement ist an seiner Oberseite, an seiner Unterseite und an seinen seitlichen Flächen vollständig von Material des Grundkörpers und den thermischen Vias eingeschlossen.

Als Via wird eine Durchkontaktierung (englisch: Vertical Interconnect Access, Via) bezeichnet, die eine vertikale elektrische Verbindung zwischen verschiedenen Ebenen des Grundkörpers ermöglicht, wobei "vertikal" hier die Richtung von der Unterseite des Grundkörpers zur Oberseite des Grundkörpers bezeichnet. Als thermisches Via wird hier eine Durchkontaktierung bezeichnet, die sich durch eine hohe Wärmeleitfähigkeit von zumindest 250 W/(m·K) auszeichnet. Ein thermisches Via dient dazu, Hitze von der Oberseite des Grundkörpers wegzuleiten. Ein thermisches Via kann Kupfer oder Silber aufweisen oder aus Kupfer oder Silber bestehen. Der beschriebene Träger zeichnet sich durch eine effiziente Ableitung der von dem Halbleiterbauelement abgestrahlten Wärme aus, die sich aufgrund des niedrigen thermischen Widerstands der thermischen Vias ergibt. Dadurch kann die Lebensdauer des Halbleiterbauelements verbessert werden. Alternativ oder ergänzend kann es ermöglicht werden, das Halbleiterbauelement mit einer größeren Leistung zu betreiben als dieses für einen vergleichbaren Träger ohne thermische Vias möglich wäre, da erst die thermischen Vias die Ableitung der auf Grund der erhöhten Leistung zusätzlich erzeugten Hitze ermöglichen.

Ferner weist der Träger erfindungsgemäß zumindest ein weiteres thermisches Via auf, das sich von der Oberseite des Grundkörpers zu der Unterseite des Grundkörpers erstreckt. Das weitere thermische Via kann ein reines thermisches Via sein, das nicht zur Kontaktierung des eingebetteten Bauelements dient. Durch das zumindest eine weitere thermische Via kann die Wärmeleitfähigkeit des Grundkörpers weiter verbessert werden.

Ferner weist der Träger erfindungsgemäß eine metallische Struktur auf, die in den Grundkörper eingebettet ist und die in eine Richtung parallel zu der Oberseite des Grundkörpers ausgedehnt ist, wobei die metallische Struktur unmittelbar an dem weiteren thermischen Via anliegt. Insbesondere kann die metallische Struktur das weitere thermische Via berühren. Die metallische Struktur kann auch an mehreren weiteren thermischen Vias unmittelbar anliegen. Durch die metallische Struktur wird weiteres Material mit einer hohen Wärmeleitfähigkeit in dem Grundkörper eingebracht, sodass die Wärmeleitfähigkeit des gesamten Grundkörpers erhöht wird. Insbesondere trägt die metallische Struktur dazu bei, Hitze schnell von der Oberseite des Grundkörpers abzuleiten. Die metallische Struktur kann beispielsweise als Block oder als Streifen ausgebildet sein.

Der Grundkörper kann einen Mehrschichtaufbau aufweisen, wobei die metallische Struktur und das eingebettete elektrische Bauelement in der gleichen Schicht angeordnet sind.

Bei dem eingebetteten elektrischen Bauelement kann es sich um einen Varistor, eine Diode, einen NTC-Thermistor, einen PTC-Thermistor, einen Keramikvielschicht-Chipkondensator, eine Vielschichtinduktivität oder eine Treiberschaltung für das zumindest eine Halbleiterbauelement handeln.

Das eingebettet Bauelement kann dazu geeignet sein, das Halbleiterbauelement vor Beschädigung durch eine zu hohe angelegte Spannung zu schützen. Ein solches ESD-Schutzbauelement kann beispielsweise ein Varistor oder eine Diode sein.

Das eingebettete Bauelement kann auch eine definierte thermische Anbindung des Halbleiterbauelements ermöglichen. Hierzu eignen sich insbesondere NTC- und PTC-Thermistoren. Diese können bei einer entsprechenden Verschaltung mit dem Halbleiterbauelement eine Beschädigung des Halbleiterbauelements durch zu hohen Temperaturen verhindern.

Es ist auch möglich, dass es sich bei dem eingebetteten Bauelement um einen Treiberschaltkreis oder einen Regelschaltkreis zum Ansteuern des Halbleiterbauelements handelt.

Das eingebettete Bauelement kann insbesondere jede aktive elektronische Komponente (wie zum Beispiel ein elektronischer Chip, insbesondere ein Halbleiterchip) oder jede beliebige passive elektronische Komponente (wie zum Beispiel ein Kondensator, ein Widerstand, ein Varistor, ein NTC, ein PTC oder eine Induktivität) sein. Beispiele der eingebetteten Bausteine bzw. Komponenten sind ein Datenspeicher wie zum Beispiel ein DRAM (oder jeder andere beliebige Speicher), ein Filter (der zum Beispiel als ein Hochpassfilter, ein Tiefpassfilter oder ein Bandpassfilter konfiguriert sein kann, und der zum Beispiel zum Frequenzfiltern dienen kann), ein integrierter Schaltkreis (wie zum Beispiel ein Logik IC), eine Signalverarbeitungskomponente (wie zum Beispiel ein Mikroprozessor), eine Leistungsmanagementkomponente, ein optisch-elektrisches Schnittstellenelement (zum Beispiel ein optoelektronisches Bauelement), ein Spannungswandler (wie zum Beispiel ein DC/DC Konverter oder ein AC/DC Konverter), ein elektromechanischer Wandler (z.B. ein PZT (Blei-Zirkonat-Titanat) Sensor und/oder Aktor), eine Sende- und/oder Empfangseinheit für elektromagnetische Wellen (z. B. ein RFID-Chip oder Transponder), eine kryptografische Komponente, eine Kapazität, eine Induktivität, ein Schalter (zum Beispiel ein Transistor-basierter Schalter) und eine Kombination von diesen und anderen funktionalen elektronischen Bauteilen. Die Komponente kann auch ein mikroelektromechanisches System (MEMS), eine Batterie, eine Kamera oder eine Antenne aufweisen.

Der Grundkörper kann ein mindestens ein Material aus einer Gruppe aufweisen, die besteht aus Harz, insbesondere Bismaleimid-Triazin Harz, Glas, insbesondere Glasfasern, Prepreg-Material, Polyimid, ein Flüssigkristall-Polymer, Cyanatester, Epoxid-basierten Build-Up Film, FR4 Material, einer Keramik, und einem Metalloxid. FR4 bezeichnet eine Klasse von Verbundwerkstoffen bestehend aus Epoxidharz und Glasfasergewebe. Harz-Glasfaserlaminate zeichnen sich durch eine hohe Spannungsfestigkeit und eine hohe mechanische Festigkeit aus. Außerdem können sie einen Wärmedehnungskoeffizienten aufweisen, der gut an den Wärmedehnungskoeffizienten des Halbleiterbauelements angepasst ist, so dass thermomechanische Störeinflüsse gering gehalten werden können.

Der Träger weist erfindungsgemäß eine Höhe von weniger als 500 µm auf, vorzugsweise eine Höhe von weniger als 350 µm. Insbesondere kann der Träger eine Höhe zwischen 200 und 500 µm, vorzugsweise zwischen 200 und 350 µm, aufweisen. Eine solche geringe Höhe wird durch die Integration des elektrischen Bauelementes in dem Träger ermöglicht. Auf diese Weise können Träger konstruiert werden, die kein auf der Trägeroberseite angeordnetes Bauelement aufweisen. Es ist jedoch auch möglich, den Träger derart auszugestalten, dass weitere elektrische Bauelemente als SMD-Bauelement (SMD = Surface Mounted Device) auf der Oberfläche angeordnet sind.

Der Träger kann ferner ein drittes thermisches Via aufweisen, das sich von der Oberseite des Grundkörpers zu dem elektrischen Bauelement erstreckt, und ein viertes thermisches Via aufweisen, das sich von dem elektrischen Bauelement zu der Unterseite des Grundkörpers erstreckt. Das eingebettete elektrische Bauelement kann dabei auch durch das dritte und das vierte thermische Via elektrisch kontaktiert sein.

Ferner kann zumindest ein zweites elektrisches Bauelement in dem Grundkörper eingebettet sein, wobei der Träger ein fünftes thermisches Via aufweist, das sich von der Oberseite des Grundkörpers zu dem zweiten elektrischen Bauelement erstreckt, wobei der Träger ein sechstes thermisches Via aufweist, das sich von dem elektrischen Bauelement zu der Unterseite des Grundkörpers erstreckt, und wobei das eingebettete elektrische Bauelement durch das fünfte und das sechste thermische Via elektrisch kontaktiert ist. Dementsprechend kann der Träger mehrere eingebettete elektrische Bauelemente aufweisen. Beispielsweise könnten das erste eingebettete Bauelement ein ESD-Schutzbauelement, wie etwa ein Varistor oder eine Diode, und das zweite eingebettete Bauelement ein Temperatursensor oder ein Bauelement zur Kontrolle der thermischen Anbindung des Halbleiterbauelements, wie etwa einem PTC- oder einem NTC-Thermistor, sein, wobei beide Bauelemente mit demselben Halbleiterbauelement verschaltbar sind. Die Verschaltung des Halbleiterbauelements mit einem PTC-Thermistor kann das Halbleiterbauelement vor Überströmen schützen. Die Verschaltung des Halbleiterbauelements mit einem NTC-Thermistor kann das Halbleiterbauelement vor Überhitzung schützen.

Gemäß einem weiteren Aspekt wird eine Vorrichtung vorgeschlagen, die den oben beschriebenen Träger und ein Halbleiterbauelement aufweist, wobei das Halbleiterbauelement auf der Oberseite des Trägers angeordnet ist.

Bei dem Halbleiterbauelement kann es sich um eine Leuchtdiode handeln.

Im nachfolgenden wird die Erfindung anhand von Figuren detaillierter beschrieben.

Figur 1 zeigt ein erstes nicht alle Merkmale der Erfindung umfassendes exemplarisches Ausführungsbeispiel einer Vorrichtung.

Die Figuren 2 und 3 zeigen ein zweites nicht alle Merkmale der Erfindung umfassendes exemplarisches Ausführungsbeispiel einer Vorrichtung.

Die Figuren 4 und 5 zeigen in einer perspektivischen Ansicht ein drittes der Erfindung entsprechendes

Ausführungsbeispiel für einen Träger für ein Halbleiterbauelement.

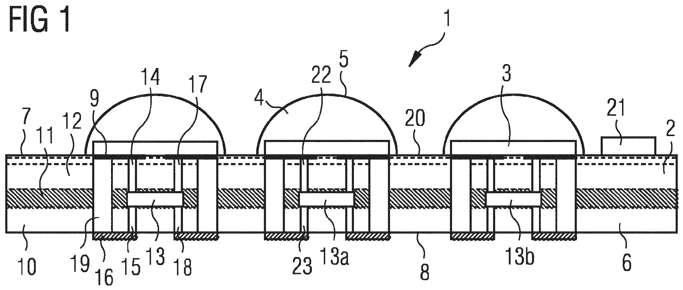

Figur 1 zeigt ein erstes nicht alle Merkmale der Erfindung umfassendes exemplarisches Ausführungsbeispiel einer Vorrichtung 1. Die Vorrichtung 1 weist einen Träger 2 für mehrere Halbleiterbauelemente 3 auf. Die Halbleiterbauelemente 3 sind hier jeweils Leuchtdioden. Auf dem Träger 2 sind drei Halbleiterbauelemente 3 angeordnet. Auf jedem Halbleiterbauelemente 3 ist eine als Linse ausgebildete Schutzschicht 4 angeordnet. Die Schutzschicht 4 weist Silikon auf. Ferner ist die Schutzschicht 4 mit einer weiteren Phosphorschicht 5 überzogen.

Der Träger 2 weist einen Grundkörper 6 mit einer Oberseite 7 und einer Unterseite 8 auf. Der Träger 2 ist so ausgestaltet, dass die Halbleiterbauelemente 3 auf der Oberseite 7 des Grundkörpers 6 befestigt, beispielsweise angelötet, werden können. Dazu weist der Grundkörper 6 auf seiner Oberseite 7 Kontaktflächen 9 auf.

Der Grundkörper 6 weist erfindungsgemäß einen Mehrschichtaufbau auf. Dabei weist der Grundkörper 6 zumindest eine untere Schicht 10, eine mittlere Schicht 11 und eine obere Schicht 12 auf. Die untere Schicht 10 weist die Unterseite 8 des Grundkörpers 6 auf. Die obere Schicht 12 weist die Oberseite 7 des Grundkörpers 6 auf. Die mittlere Schicht 11 ist zwischen der unteren und der oberen Schicht 10, 12 angeordnet. Jede dieser Schichten 10, 11, 12 weist eine Glasfaser-Harz-Mischung auf. Die Schichten 10, 11, 12 des Grundkörpers 6 können sich voneinander in dem Mischverhältnis von Glasfaser zu Harz unterscheiden. Die Schichten weisen ein FR4 auf.

In der mittleren Schicht 11 des Grundkörpers 6 ist ein elektrisches Bauelement 13 eingebettet. Die mittlere Schicht 11 weist Öffnungen in der Glasfaser-Harzschicht auf, in denen das eingebettete elektrische Bauelement 13 angeordnet ist. Das Bauelement 13 ist seitlich durch die mittlere Schicht 11 begrenzt. Über dem Bauelement 13 ist die obere Schicht 12 angeordnet und unter dem Bauelement 13 ist die untere Schicht 10 angeordnet. Dementsprechend ist das Bauelement 13 auf jeder Seite durch eine Schicht 10, 11, 12 des Grundkörpers 6 eingeschlossen.

Bei dem Bauelement 13 kann es sich um einen Varistor, eine Diode, einen NTC-Thermistor, einen PTC-Thermistor, einen Keramikvielschicht-Chipkondensator (englisch: Multi Layer Ceramic Capacitor, MLCC), eine Vielschichtinduktivität (englisch: Multi Layer Induktor, ML-Inductor) oder eine Treiberschaltung für das Halbleiterbauelement 3 handeln.

Der Träger 2 weist ferner ein erstes thermisches Via 14 auf, das sich von der Oberseite 7 des Grundkörpers 6 zu dem elektrischen Bauelement 13 erstreckt. Das erste thermische Via 14 kontaktiert dabei das elektrische Bauelement 13 mit einer der auf der Oberseite 7 angeordneten Kontaktfläche 9.

Ferner weist der Träger 2 ein zweites thermisches Via 15 auf, das sich von dem elektrischen Bauelement 13 zu der Unterseite 8 des Grundkörpers 6 erstreckt. Das zweite thermische Via 15 kontaktiert dabei das Bauelement 13 mit einem auf der Unterseite 8 des Grundkörpers 6 angeordneten elektrischen Kontakt 16. Dementsprechend sorgen das erste und das zweite thermische Via 14, 15 für eine elektrische Kontaktierung des Bauelements 13.

Ferner weist der Träger 2 ein drittes thermisches Via 17, das sich von der Oberseite 7 zu dem Bauelement 13 erstreckt, und ein viertes thermisches Via 18 auf, das sich von dem eingebetteten elektrischen Bauelement 13 zu der Unterseite 8 erstreckt. Auch über das dritte und das vierte thermische Via 17, 18 ist das eingebettete Bauelement 13 elektrisch kontaktiert.

Das erste bis vierte thermische Via 14, 15, 17, 18 erfüllen im vorliegenden Träger 2 zwei Funktionen. Zum einen sorgen sie für die elektrische Kontaktierung des eingebetteten Bauelements 13. Zum anderen reduzieren sie den thermischen Widerstand des Trägers 2. Dementsprechend ermöglichen es die ersten bis vierten thermischen Vias 14, 15, 17, 18 von dem Halbleiterbauelement 3 erzeugte Hitze schnell und effektiv von der Oberseite 7 des Grundkörpers 6 wegzuleiten. Auf diese Weise sorgen die thermischen Vias 14, 15, 17, 18 für eine passive Kühlung des Trägers 2 und des Halbleiterbauelements 3. Die thermischen Vias 14, 15, 17, 18 weisen dazu ein Material auf, das eine hohe Wärmeleitfähigkeit besitzt. Die thermischen Vias 14, 15, 17, 18 weisen beispielsweise Kupfer oder Silber auf. Sie können auch aus Kupfer oder Silber bestehen. Beide Materialien zeichnen sich durch eine sehr hohe Wärmeleitfähigkeit aus. Reines Kupfer hat eine Wärmeleitfähigkeit von 401 W/(m·K). Reines Silber hat eine Wärmeleitfähigkeit von 429 W/(m·K).

Ferner weist der Träger 2 weitere thermische Via 19 auf, die sich von der Oberseite 7 zu der Unterseite 8 erstrecken. Diese weiteren thermischen Vias 19 dienen einzig der Aufgabe, den thermischen Widerstand des Trägers 2 zu reduzieren, d.h. für eine passive Kühlung des Trägers 2 und des Halbleiterbauelements 3 zu sorgen. Diese weiteren thermischen Vias 19 weisen ebenfalls Kupfer oder Silber auf. Die weiteren thermischen Vias 19 sind nicht mit dem eingebetteten Bauelement 13 kontaktiert.

Die weiteren thermischen Vias 19 weisen einen größeren Durchmesser auf als die ersten bis vierten thermischen Vias 14, 15, 17, 18, mit denen das elektrische Bauelement 13 kontaktiert ist. Insbesondere weisen die weiteren thermischen Vias 19 einen Durchmesser zwischen 100 und 200 µm auf, vorzugsweise zwischen 130 und 170 µm. Die ersten bis vierten thermischen Vias 14, 15, 17, 18 weisen einen Durchmesser zwischen 40 und 100 µm, vorzugsweise zwischen 40 und 70 µm, auf.

Die Oberseite 7 des Grundkörpers 6 ist mit einer Reflexionsschicht 20 beschichtet. Diese ist dazu geeignet, von dem Halbleiterbauelement 3 abgestrahltes Licht zu reflektieren und so den Reflexionsgrad des Trägers 2 zu verbessern. Die Reflexionsschicht 20 kann einen gefüllten Polymer oder gefülltes Glas aufweisen.

Ferner ist auf der Oberseite 7 des Trägers 2 ein SMD-Bauelement 21 (SMD = surface mounted device) angeordnet, das nicht in dem Grundkörper 6 eingebettet ist.

In dem Grundkörper 6 sind ein zweites elektrisches Bauelement 13a und ein drittes elektrisches Bauelement 13b eingebettet. Diese sind jeweils mit auf der Oberseite 7 des Grundkörpers angeordneten Kontaktflächen 9 elektrisch über thermische Vias verbunden. Beispielsweise ist das zweite elektrische Bauelement 13a über ein fünftes thermisches Via 22 mit der Oberseite 7 verbunden.

Ferner sind das zweite und das dritte Bauelement 13a, 13b über thermische Vias mit elektrischen Kontakten 16 auf der Unterseite 8 des Grundkörpers 6 elektrisch verbunden. Beispielsweise ist das zweite Bauelement 13a über ein sechstes thermisches Via 23 mit der Unterseite 8 verbunden.

Das zweite und das dritte eingebettete Bauelement 13a, 13b können in gleicherweise wie das erste eingebettete Bauelement 13 ausgestaltet und verschaltet sein. Die im Zusammenhang mit dem ersten Bauelement 13 beschriebenen Merkmale treffen auch auf das zweite und das dritte eingebettete Bauelement 13a, 13b zu.

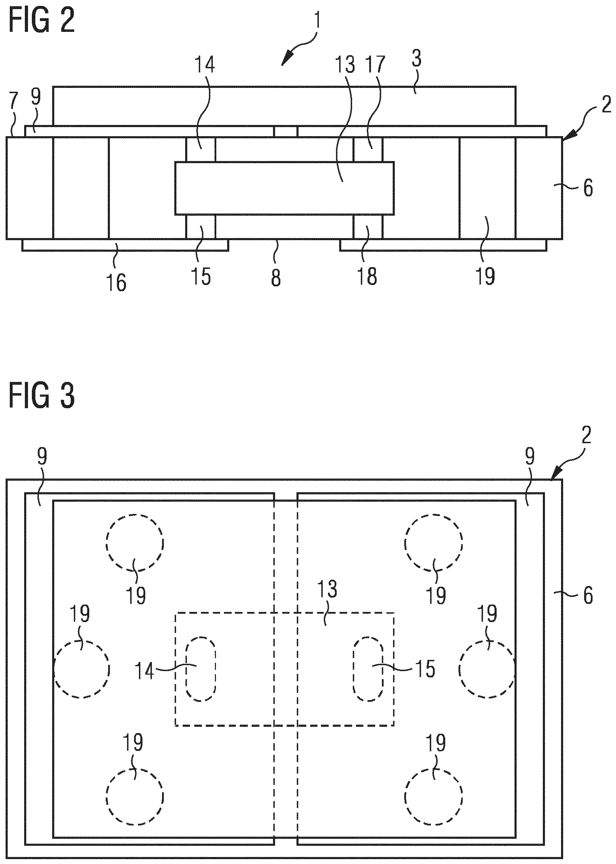

Die Figuren 2 und 3 zeigen ein zweites nicht alle Merkmale der Erfindung umfassendes exemplarisches Ausführungsbeispiel einer Vorrichtung 1, bestehend aus einem Halbleiterbauelement 3 und einem Träger 2 für das Halbleiterbauelement 3, wobei es sich bei dem Halbleiterbauelement 3 um eine Leuchtdiode handelt. Figur 2 zeigt einen Querschnitt durch die Vorrichtung 1 entlang einer vertikalen Ebene und Figur 3 zeigt einen horizontalen Querschnitt.

Die Vorrichtung 1 gemäß dem zweiten Ausführungsbeispiel entspricht im Wesentlichen der Vorrichtung 1 gemäß dem ersten Ausführungsbeispiel erläutert. Auf dem Träger 2 sind jedoch hier lediglich Kontaktflächen 9 für eine einziges Halbleiterbauelement 3 vorgesehen. Es ist ferner genau ein Bauelement 13 in den Grundkörper 6 eingebettet.

Das eingebettete Bauelement 13 kann ZnOPr aufweisen, das eine Wärmeleitfähigkeit von 40 W/(m·K) aufweist. Der Grundkörper 6 kann ein FR4 mit einer Wärmeleitfähigkeit von 0,62 W/(m·K) aufweisen. Wie oben beschrieben können die thermischen Vias 14, 15, 17, 18, 19 dagegen eine wesentlich höhere Wärmeleitfähigkeit aufweisen.

Der Träger 2 kann eine Höhe von weniger als 500 µm, vorzugsweise eine Höhe zwischen 200 und 350 µm aufweisen. Ein solcher Träger 2 ist wesentlich niedriger als Träger 2, bei denen auf der Oberseite 7 SMD-Bauelemente 21 angeordnet sind. Dementsprechend kann durch das Einbetten des elektrischen Bauelements 13 in dem Träger 2 die Gesamthöhe der Anordnung wesentlich reduziert werden. Es können auch mehrere Bauelemente 13, 13a, 13b in einen Träger mit einer Höhe von weniger als 500 µm eingebettet sein.

In Figur 3 ist die Anordnung der weiteren thermischen Vias 19 sowie des ersten und des dritten thermischen Vias 14, 17 zu erkennen. Die weiteren Vias 19 sind um das eingebettete Bauelement 13 herum angeordnet. Figur 3 zeigt, dass diese weiteren Vias 19 einen vergleichsweise großen Querschnitt aufweisen, der ihre Wärmeleitfähigkeit verbessert. Das erste und das dritte Via 14, 17 haben einen längliche Querschnitt. Auch das zweite und das vierte Via 15, 18 können einen solchen länglichen Querschnitt aufweisen.

Die weiteren thermischen Vias 19 haben einen Durchmesser von 150 µm und einen Mindestabstand voneinander von zumindest 200 µm. Die weiteren Vias 19 weisen zu dem eingebetteten Bauelement 13 einen Mindestabstand von 200 µm auf. Die weiteren Vias 19 weisen vom Rand des Trägers 2 einen Abstand von zumindest 125 µm auf. Das eingebettete Bauelement 13 weist vom Rand einen Abstand von zumindest 380 µm auf. Das eingebettete Bauelement 13 weist eine Höhe zwischen 80 und 200 µm auf, bei einer Gesamthöhe des Grundkörpers 6 von 300 µm. Das erste bis vierte Via 14, 15, 17, 18 weisen jeweils in einer ersten Richtung eine Ausdehnung von 60 µm und in eine zweite Richtung, die zur ersten Richtung senkrecht ist, eine Ausdehnung von 100 µm auf. Die untere und die obere Schicht 10, 12 des Grundkörpers 6 weisen eine Dicke von zumindest 50 µm auf. Die auf der Ober- und der Unterseite 7, 8 des Grundkörpers 6 angeordneten Kontaktflächen 9, 16 bestehen aus Kupfer und weisen eine Dicke von 30 +/- 10 µm auf. Sie sind von den seitlichen Rändern des Grundkörpers 6 zumindest 75 µm beabstandet. Die hier angegebenen Größen ermöglichen einen stabilen Träger 2, der sich insbesondere durch eine geringe Bauhöhe und eine hohen Wärmeleitfähigkeit auszeichnet, die es ermöglich, das Halbleiterbauelement 3 mit einer hohen Leistung zu betreiben.

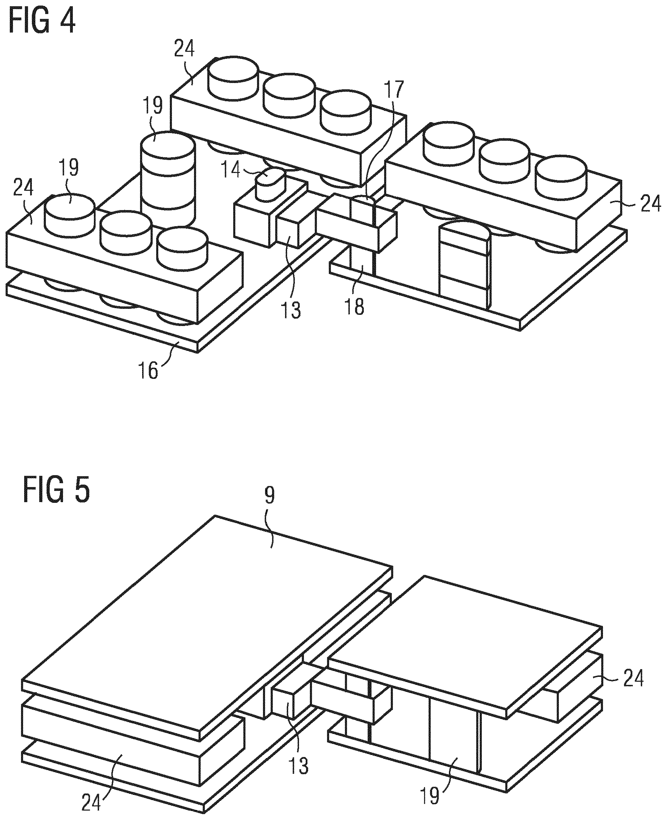

Die Figuren 4 und 5 zeigen in einer perspektivischen Ansicht ein drittes der Erfindung entsprechendes Ausführungsbeispiel für einen Träger 2 für ein Halbleiterbauelemente 3. Zur besseren Veranschaulichung sind in Figur 4 der Grundkörper 6 und die auf der Oberseite 7 des Grundkörpers angeordneten Kontaktflächen 9 nicht eingezeichnet. In Figur 5 ist nur der Grundkörper 6 nicht eingezeichnet.

Der Träger 2 gemäß der dritten Ausführungsform weist metallische Strukturen 24 auf, die in dem Grundkörper 6 eingebettet sind. Die metallischen Strukturen 24 sind in der mittleren Schicht 11 des Grundkörpers 6 angeordnet, in der auch das eingebettete elektrische Bauelement 13 angeordnet ist. Die metallischen Strukturen 24 sind jeweils mit drei weiteren thermischen Vias 19 verbunden. Insbesondere umschließen sie die weiteren thermischen Vias 19 unmittelbar und liegen an diesen an. Durch die metallischen Strukturen 24 wird die Wärmeleitfähigkeit der von diesen berührten thermischen Vias 19 verbessert.

Die Figuren 4 und 5 zeigen jeweils metallische Strukturen 24, die als Blöcke ausgebildet sind. Möglich sind auch metallische Strukturen 24 mit anderen Formen, beispielsweise Streifen oder Fenster. Ein rahmenförmiges Fenster könnte dabei beispielsweise in seiner Mitte eine Öffnung aufweisen und so angeordnet sein, dass es das in den Grundkörper 6 eingebettete metallische Bauelement 13 umschließt und dieses in der Öffnung anordnet. Ein Streifen weist nur eine sehr kleine Höhe auf, die beispielsweise geringer als 10 µm sein kann. Als Höhe wird hierbei die Ausdehnung in der Richtung von Unterseite 8 zur Oberseite 7 hin bezeichnet.

### Bezugszeichenliste

- 1: Vorrichtung
- 2: Träger
- 3: Halbleiterbauelement
- 4: Schutzschicht
- 5: Phosphorschicht
- 6: Grundkörper
- 7: Oberseite
- 8: Unterseite
- 9: Kontaktflächen
- 10: untere Schicht
- 11: mittlere Schicht
- 12: obere Schicht
- 13: elektrisches Bauelement
- 13a: elektrisches Bauelement
- 13b: elektrisches Bauelement
- 14: erstes thermisches Via
- 15: zweites thermisches Via
- 16: elektrischer Kontakt
- 17: drittes thermisches Via
- 18: viertes thermisches Via
- 19: weitere thermische Via
- 20: Reflexionsschicht
- 21: SMD-Bauelement
- 22: fünftes thermisches Via
- 23: sechstes thermisches Via
- 24: metallische Struktur

## Patentansprüche

1. Träger (2) mit passiver Kühlfunktion für ein Halbleiterbauelement (3),
aufweisend einen Grundkörper (6) mit einer Oberseite (7) und einer Unterseite (8) und zumindest ein elektrisches Bauelement (13, 13a, 13b), das in den Grundkörper (6) eingebettet ist,
wobei der Grundkörper (6) zumindest eine untere Schicht (10), eine mittlere Schicht (11) und eine obere Schicht (12) aufweist und die untere Schicht (10) die Unterseite (8) des Grundkörpers (6) und die obere Schicht (12) die Oberseite (7) des Grundkörpers (6) aufweist,
wobei der Träger (2) ein erstes thermisches Via (14) aufweist, das sich von der Oberseite (7) des Grundkörpers (6) zu dem zumindest einen elektrischen Bauelement (13, 13a, 13b) erstreckt,
wobei der Träger (2) ein zweites thermisches Via (15) aufweist, das sich von dem zumindest einen elektrischen Bauelement (13, 13a, 13b) zu der Unterseite (8) des Grundkörpers (6) erstreckt,
wobei das zumindest eine eingebettete elektrische Bauelement (13, 13a, 13b) durch das erste und das zweite thermische Via (14, 15) elektrisch kontaktiert ist,
wobei der Träger (2) zumindest ein weiteres thermisches Via (19) aufweist, das sich von der Oberseite (7) des Grundkörpers (6) zu der Unterseite (8) des Grundkörpers (6) erstreckt,
**dadurch gekennzeichnet, dass**
der Träger (2) eine Höhe von weniger als 500 µm aufweist und der Träger
ferner zumindest eine metallische Struktur (24) aufweist, die in den Grundkörper (6) eingebettet und in der mittleren Schicht (11) angeordnet ist und die in eine Richtung parallel zu der Oberseite (7) des Grundkörpers (6) ausgedehnt ist,
wobei die zumindest eine metallische Struktur (24) unmittelbar an dem weiteren thermischen Via (19) anliegt.

2. Träger (2) gemäß Anspruch 1,
wobei das weitere thermische Via (19) einen Durchmesser hat, der größer ist als der Durchmesser des ersten thermischen Vias (14) und als der Durchmesser des zweiten thermischen Vias (15).

3. Träger (2) gemäß Anspruch 1 oder 2,
wobei der Grundkörper (6) einen Mehrschichtaufbau aufweist, und wobei die metallische Struktur (24) und das zumindest eine eingebettete elektrische Bauelement (13, 13a, 13b) in der gleichen Schicht (11) angeordnet sind.

4. Träger (2) gemäß einem der vorherigen Ansprüche,
wobei es sich bei dem zumindest einen eingebetteten elektrischen Bauelement (13, 13a, 13b) um einen Varistor, eine Diode, einen NTC-Thermistor, einen PTC-Thermistor, einen Keramikvielschicht-Chipkondensator, eine Vielschichtinduktivität oder eine Treiberschaltung für das Halbleiterbauelement (3) handelt.

5. Träger (2) gemäß einem der vorherigen Ansprüche,
wobei es sich bei dem zumindest einen eingebetteten elektrischen Bauelement (13, 13a, 13b) entweder um eine aktive elektronische Komponente, beispielsweise einen elektronischen Chip, insbesondere ein Halbleiterchip, oder um eine passive elektronische Komponente, beispielsweise einen Kondensator, einen Widerstand, einen Varistor, einen NTC, einen PTC oder eine Induktivität oder um einen eingebetteten Bausteine handelt,
wobei der eingebettete Baustein beispielsweise ein Datenspeicher, wie zum Beispiel ein DRAM oder jeder andere beliebige Speicher, ein Filter, der zum Beispiel als ein Hochpassfilter, ein Tiefpassfilter oder ein Bandpassfilter konfiguriert sein kann und der zum Beispiel zum Frequenzfiltern dienen kann, ein integrierter Schaltkreis, wie zum Beispiel ein Logik IC, eine Signalverarbeitungskomponente, wie zum Beispiel ein Mikroprozessor, eine Leistungsmanagementkomponente, ein optisch-elektrisches Schnittstellenelement, zum Beispiel ein optoelektronisches Bauelement, ein Spannungswandler, wie zum Beispiel ein DC/DC Konverter oder ein AC/DC Konverter, ein elektromechanischer Wandler, z.B. ein PZT Sensor und/oder Aktor, eine Sende- und/oder Empfangseinheit für elektromagnetische Wellen, z. B. ein RFID-Chip oder Transponder, eine kryptografische Komponente, eine Kapazität, eine Induktivität, ein Schalter, zum Beispiel ein Transistor-basierter Schalter und eine Kombination von diesen und anderen funktionalen elektronischen Bauteilen ist,
und/oder
wobei das eingebetteten elektrischen Bauelement (13, 13a, 13b) ein mikroelektromechanisches System (MEMS), eine Batterie, eine Kamera oder eine Antenne aufweist.

6. Träger (2) gemäß einem der vorherigen Ansprüche,
wobei der Grundkörper (6) mindestens ein Material aus einer Gruppe aufweist, die besteht aus Harz, insbesondere Bismaleimid-Triazin Harz, Glas, insbesondere Glasfasern, Prepreg-Material, Polyimid, ein Flüssigkristall-Polymer, Cyanatester, Epoxid-basierten Build-Up Film, FR4 Material, einer Keramik, und einem Metalloxid.

7. Träger (2) gemäß einem der vorherigen Ansprüche,
wobei der Träger (2) ein drittes thermisches Via (17) aufweist, das sich von der Oberseite (7) des Grundkörpers (6) zu dem zumindest einen elektrischen Bauelement (13, 13a, 13b) erstreckt,
wobei der Träger (2) ein viertes thermisches Via (18) aufweist, das sich von dem zumindest einen elektrischen Bauelement (13, 13a, 13b) zu der Unterseite (8) des Grundkörpers (6) erstreckt,
wobei das zumindest eine eingebettete elektrische Bauelement (13, 13a, 13b) auch durch das dritte und das vierte thermische Via (17, 18) elektrisch kontaktiert ist.

8. Träger (2) gemäß einem der vorherigen Ansprüche,
wobei zumindest ein zweites elektrisches Bauelement (13a) in den Grundkörper (6) eingebettet ist,
wobei der Träger (2) ein fünftes thermisches Via (22) aufweist, das sich von der Oberseite (7) des Grundkörpers (6) zu dem zweiten elektrischen Bauelement (13b) erstreckt,
wobei der Träger (2) ein sechstes thermisches Via (23) aufweist, das sich von dem zweiten elektrischen Bauelement (13b) zu der Unterseite (8) des Grundkörpers (6) erstreckt, und
wobei das zweite eingebettete elektrische Bauelement (13b) durch das fünfte und das sechste thermische Via (22, 23) elektrisch kontaktiert ist.

9. Vorrichtung,
aufweisend einen Träger (2) gemäß einem der vorherigen Ansprüche und ein Halbleiterbauelement (3), das auf der Oberseite (7) des Trägers (2) angeordnet ist.

## Claims

1. Carrier (2) with a passive cooling function for a semiconductor component (3),
having a main body (6) with a top side (7) and a bottom side (8) and at least one electrical component (13, 13a, 13b) that is embedded in the main body (6),
wherein the main body (6) has at least one bottom layer (10), one middle layer (11) and one top layer (12) and the bottom layer (10) has the bottom side (8) of the main body (6) and the top layer (12) has the top side (7) of the main body (6),
wherein the carrier (2) has a first thermal via (14), which extends from the top side (7) of the main body (6) to the at least one electrical component (13, 13a, 13b), wherein the carrier (2) has a second thermal via (15), which extends from the at least one electrical component (13, 13a, 13b) to the bottom side (8) of the main body (6),
wherein the at least one embedded electrical component (13, 13a, 13b) is electrically contacted by the first and the second thermal via (14, 15),
wherein the carrier (2) has at least one further thermal via (19), which extends from the top side (7) of the main body (6) to the bottom side (8) of the main body (6), **characterized in that**
the carrier (2) has a height of less than 500 µm and the carrier furthermore has at least one metallic structure (24) that is embedded in the main body (6) and is arranged in the middle layer (11) and that is elongated in a direction parallel to the top side (7) of the main body (6),
wherein the at least one metallic structure (24) directly abuts the further thermal via (19).

2. Carrier (2) according to Claim 1,
wherein the further thermal via (19) has a diameter that is greater than the diameter of the first thermal via (14) and than the diameter of the second thermal via (15) .

3. Carrier (2) according to Claim 1 or 2,
wherein the main body (6) has a multilayer construction and wherein the metallic structure (24) and the at least one embedded electrical component (13, 13a, 13b) are arranged in the same layer (11).

4. Carrier (2) according to one of the preceding claims,
wherein the at least one embedded electrical component (13, 13a, 13b) is a varistor, a diode, an NTC thermistor, a PTC thermistor, a multilayer ceramic chip capacitor, a multilayer inductance or a driver circuit for the semiconductor component (3).

5. Carrier (2) according to one of the preceding claims,
wherein the at least one embedded electrical component (13, 13a, 13b) is either an active electronic component, for example an electronic chip, in particular a semiconductor chip, or a passive electronic component, for example a capacitor, a resistor, a varistor, an NTC, a PTC or an inductance or is an embedded module, wherein the embedded module is, for example, a data memory, such as, for example, a DRAM or any other desired memory, a filter, which may be configured as a high-pass filter, a low-pass filter or a band-pass filter, for example, and which may serve for frequency filtering, for example, an integrated circuit, such as, for example, a logic IC, a signal processing component, such as, for example, a microprocessor, a power management component, an optical-electrical interface element, for example an optoelectronic component, a voltage converter, such as, for example, a DC/DC converter or an AC/DC converter, an electromechanical converter, for example a PZT sensor and/or actuator, a transmission and/or reception unit for electromagnetic waves, for example an RFID chip or transponder, a cryptographic component, a capacitance, an inductance, a switch, for example a transistor-based switch and a combination of these and other functional electronic component parts, and/or
wherein the embedded electrical component (13, 13a, 13b) has a microelectromechanical system (MEMS), a battery, a camera or an antenna.

6. Carrier (2) according to one of the preceding claims,
wherein the main body (6) comprises at least one material from a group consisting of resin, in particular bismaleimide-triazine resin, glass, in particular glass fibres, prepreg material, polyimide, a liquid-crystal polymer, cyanate esters, epoxy-based build-up film, FR4 material, a ceramic and a metal oxide.

7. Carrier (2) according to one of the preceding claims,
wherein the carrier (2) has a third thermal via (17), which extends from the top side (7) of the main body (6) to the at least one electrical component (13, 13a, 13b), wherein the carrier (2) has a fourth thermal via (18), which extends from the at least one electrical component (13, 13a, 13b) to the bottom side (8) of the main body (6),
wherein the at least one embedded electrical component (13, 13a, 13b) is also electrically contacted by the third and the fourth thermal via (17, 18).

8. Carrier (2) according to one of the preceding claims,
wherein at least one second electrical component (13a) is embedded in the main body (6),
wherein the carrier (2) has a fifth thermal via (22), which extends from the top side (7) of the main body (6) to the second electrical component (13b),
wherein the carrier (2) has a sixth thermal via (23), which extends from the second electrical component (13b) to the bottom side (8) of the main body (6), and wherein the second embedded electrical component (13b) is electrically contacted by the fifth and the sixth thermal via (22, 23).

9. Apparatus,
having a carrier (2) according to one of the preceding claims and a semiconductor component (3) that is arranged on the top side (7) of the carrier (2).

## Revendications

1. Support (2) présentant une fonction de refroidissement passif pour un composant semi-conducteur (3),
présentant un corps de base (6) ayant une face supérieure (7) et une face inférieure (8) et au moins un composant électrique (13, 13a, 13b) qui est encapsulé dans le corps de base (6),
dans lequel le corps de base (6) présente au moins une couche inférieure (10), une couche médiane (11) et une couche supérieure (12) et la couche inférieure (10) présente la face inférieure (8) du corps de base (6) et la couche supérieure (12) présente la face supérieure (7) du corps de base (6),
dans lequel le support (2) présente un premier via thermique (14) qui s'étend de la face supérieure (7) du corps de base (6) vers ledit au moins un composant électrique (13, 13a, 13b),
dans lequel le support (2) présente un deuxième via thermique (15) qui s'étend dudit au moins un composant électrique (13, 13a, 13b) vers la face inférieure (8) du corps de base (6),
dans lequel ledit au moins un composant électrique encapsulé (13, 13a, 13b) est en contact électrique par l'intermédiaire du premier et du deuxième via thermique (14, 15),
dans lequel le support (2) présente au moins un autre via thermique (19) qui s'étend de la face supérieure (7) du corps de base (6) vers la face inférieure (8) du corps de base (6),
**caractérisé en ce que** le support (2) présente une hauteur inférieure à 500 µm et le support présente en outre au moins une structure métallique (24) qui est encapsulée dans le corps de base (6) et disposée dans la couche intermédiaire (11) et qui s'étend dans une direction parallèle à la face supérieure (7) du corps de base (6), dans lequel ladite au moins une structure métallique (24) est directement adjacente à l'autre via thermique (19).

2. Support (2) selon la revendication 1,
dans lequel l'autre via thermique (19) a un diamètre qui est supérieur au diamètre du premier via thermique (14) est au diamètre du deuxième via thermique (15).

3. Support (2) selon la revendication 1 ou 2,
dans lequel le corps de base (6) présente une structure multicouche, et dans lequel la structure métallique (24) et ledit au moins un composant électrique intégré (13, 13a, 13b) sont disposés dans la même couche (11).

4. Support (2) selon l'une quelconque des revendications précédentes,
dans lequel ledit au moins un composant électrique encapsulé (13, 13a, 13b) est une varistance, une diode, une thermistance NTC, une thermistance PTC, un condensateur à puce céramique multicouche, une inductance multicouche ou un circuit d'attaque destiné au composant semi-conducteur (3).

5. Support (2) selon l'une quelconque des revendications précédentes,
dans lequel ledit au moins un composant électrique encapsulé (13, 13a, 13b) est soit un composant électronique actif, par exemple une puce électronique, en particulier une puce semi-conductrice, soit un composant électronique passif, par exemple un condensateur, une résistance, une varistance, un NTC, un PTC ou une inductance, soit un composant encapsulé, dans lequel le composant encapsulé est par exemple une mémoire de données, comme par exemple une DRAM ou toute autre mémoire, un filtre, qui peut par exemple être configuré comme un filtre passe-haut, un filtre passe-bas ou un filtre passe-bande et qui peut par exemple être utilisé pour le filtrage de fréquence, un circuit intégré, comme par exemple un circuit intégré logique, un composant de traitement du signal, comme par exemple un microprocesseur, un composant de gestion de puissance, un composant d'interface optique-électrique, comme par exemple un composant optoélectronique, un convertisseur de tension, comme par exemple un convertisseur DC/DC ou un convertisseur AC/DC, un convertisseur électromécanique, par exemple un capteur et/ou un actionneur PZT, une unité d'émission et/ou de réception d'ondes électromagnétiques, par exemple une puce ou un transpondeur RFID, un composant cryptographique,
une capacité, une inductance, un commutateur, par exemple un commutateur à transistors et une combinaison de ceux-ci et d'autres composants électroniques fonctionnels, et/ou
dans lequel le composant électrique encapsulé (13, 13a, 13b) présente un système microélectromécanique (MEMS), une batterie, une caméra ou une antenne.

6. Support (2) selon l'une quelconque des revendications précédentes,
dans lequel le corps de base (6) présente au moins un matériau d'un groupe constitué par une résine, en particulier une résine de bismaléimide-triazine, du verre, en particulier des fibres de verre, un matériau préimprégné, un polyimide, un polymère à cristaux liquides, un ester de cyanate, un film d'accumulation à base d'époxy, un matériau FR4, une céramique et un oxyde métallique.

7. Support (2) selon l'une quelconque des revendications précédentes,
dans lequel le support (2) comprend un troisième via thermique (17) qui s'étend de la surface supérieure (7) du corps de base (6) vers ledit au moins un composant électrique (13, 13a, 13b),
dans lequel le support (2) présente un quatrième via thermique (18) qui s'étend dudit au moins un composant électrique (13, 13a, 13b) vers la face inférieure (8) du corps de base (6),
dans lequel ledit au moins un composant électrique encapsulé (13, 13a, 13b) est également en contact électrique par l'intermédiaire du troisième et du quatrième via thermique (17, 18).

8. Support (2) selon l'une quelconque des revendications précédentes,
dans lequel au moins un deuxième composant électrique (13a) est encapsulé dans le corps de base (6),
dans lequel le support (2) présente un cinquième via thermique (22) qui s'étend de la face supérieure (7) du corps de base (6) vers le deuxième composant électrique (13b),
dans lequel le support (2) présente un sixième via thermique (23) qui s'étend du deuxième composant électrique (13b) vers la face inférieure (8) du corps de base (6), et
dans lequel le deuxième composant électrique encapsulé (13b) est en contact électrique par l'intermédiaire du cinquième et du sixième via thermique (22, 23).

9. Dispositif présentant un support (2) selon l'une quelconque des revendications précédentes et un composant semi-conducteur (3) qui est disposé sur la face supérieure (7) du support (2).
